# EUROPÄISCHE PATENTSCHRIFT

(11) **EP 2 652 811 B1**
(45) Veröffentlichungstag und Bekanntmachung des Hinweises auf die Patenterteilung: **08.07.2015**
(21) Anmeldenummer: 11799249.5
(22) Anmeldetag: 23.11.2011
(51) Int. Cl.: H01L 51/50, H01L 51/54

(54) **OPTOELEKTRONISCHES BAUELEMENT UND VERWENDUNG EINES KUPFERKOMPLEXES IN EINER LADUNGSERZEUGUNGSSCHICHTFOLGE**
OPTOELECTRONIC COMPONENT, AND USE OF A COPPER COMPLEX IN A CHARGE GENERATION LAYER SEQUENCE
COMPOSANT OPTOÉLECTRONIQUE ET UTILISATION D'UN COMPLEXE DE CUIVRE DANS UNE SUCCESSION DE COUCHES DE GÉNÉRATION DE CHARGE

(30) Priorität: 13.12.2010 DE 102010062954
(43) Veröffentlichungstag der Anmeldung: 23.10.2013
(73) Patentinhaber: OSRAM Opto Semiconductors GmbH, 93055 Regensburg (DE)
(72) Erfinder: DIEZ, Carola, 93049 Regensburg (DE); HEUSER, Karsten, 91056 Erlangen (DE); JAEGER, Arndt, 93051 Regensburg (DE); NIEDERMEIER, Ulrich, 94339 Leiblfing (DE)
(74) Vertreter: Epping - Hermann - Fischer
(86) Internationale Anmeldenummer: PCT/EP2011/070833
(87) Internationale Veröffentlichungsnummer: WO 2012/079943

(56) Entgegenhaltungen:
- EP-A1- 1 351 558
- WO-A1-2011/033023
- US-A1- 2005 260 451
- YULIA SEVRYUGINA ET AL: "Tetranuclear copper(i) clusters: impact of bridging carboxylate ligands on solid state structure and photoluminescence", CHEMICAL COMMUNICATIONS, Nr. 37, 1. Januar 2007 (2007-01-01), Seite 3853, XP55019644, ISSN: 1359-7345, DOI: 10.1039/b707957e
- SEVRYUGINA ET AL: "X-ray structure and photoluminescence of copper(I) 2,6-bis(trifluoromethyl)benzoate", INORGANICA CHIMICA ACTA, ELSEVIER BV, NL, Bd. 360, Nr. 9, 10. Mai 2007 (2007-05-10), Seiten 3103-3107, XP022067761, ISSN: 0020-1693, DOI: 10.1016/J.ICA.2007.02.023
- SHARMA R P ET AL: "Segregated aromatic @?@?@? stacking interactions involving fluorinated and non-fluorinated benzene rings: Cu(py)2(pfb)2 and Cu(py)2(pfb)2(H2O) (py=pyridine and pfb=pentafluorobenzoate)", JOURNAL OF FLUORINE CHEMISTRY, ELSEVIER, NL, Bd. 131, Nr. 4, 1. April 2010 (2010-04-01) , Seiten 456-460, XP026972104, ISSN: 0022-1139 [gefunden am 2010-01-04]

## Beschreibung

Die vorliegende Erfindung betrifft ein optoelektronisches Bauelement, insbesondere betrifft sie ein optoelektronisches Bauelement mit einer Ladungserzeugungsschicht, sowie die Verwendung eines Kupferkomplexes in einer Ladungserzeugungsschichtfolge eines elektronischen Bauelements.

Ein optoelektronisches Bauelement ist zur Umwandlung elektrischer Energie in elektromagnetische Strahlung, wie beispielsweise in sichtbares Licht, oder für den umgekehrten Prozess ausgelegt. Man kann jeweils von einer Emittervorrichtung oder einer Detektorvorrichtung sprechen. Ein Beispiel für ein elektromagnetisches Bauelement als Emittervorrichtung ist eine lichtemittierende Vorrichtung, insbesondere eine lichtemittierende Diode (LED). Die Vorrichtung umfasst typischerweise Elektroden, zwischen denen eine aktive Zone angeordnet ist. Über die Elektroden kann der lichtemittierenden Vorrichtung ein elektrischer Strom zugeführt werden, welcher in der aktiven Zone in optische Energie, d.h. elektromagnetische Strahlung gewandelt wird. Die optische Energie wird über eine Strahlungsauskopplungsfläche aus der lichtemittierenden Vorrichtung ausgekoppelt.

Eine besondere lichtemittierende Vorrichtung ist die organische lichtemittierende Diode (OLED). Eine OLED weist in der aktiven Schicht eine organische Schicht auf, um elektrische Energie in elektromagnetische Strahlung zu wandeln. Bei Kontaktierung der OLED über die Elektroden mit einer Stromquelle werden unterschiedliche Ladungsträgertypen in die organische Schicht injiziert. Positive Ladungsträger, auch als Löcher bezeichnet, wandern von der Anode hin zur Kathode durch die organische Schicht, während Elektronen die organische Schicht von der Kathode hin zur Anode durchwandern. Dabei bilden sich in der organischen Schicht Anregungszustände in Form von Elektron-Lochpaaren, sogenannte Exzitonen, die unter Emission von elektromagnetischer Strahlung zerfallen.

Ein weiteres Beispiel für ein optoelektronisches Bauelement ist die Detektorvorrichtung, in der optische Strahlung in ein elektrisches Signal bzw. in elektrische Energie gewandelt wird. Ein solches optoelektronisches Bauelement ist beispielsweise ein Photodetektor oder eine Solarzelle. Auch eine Detektorvorrichtung weist eine zwischen Elektroden angeordnete aktive Schicht auf. Die Detektorvorrichtung weist eine Strahlungseintrittsseite auf, über die elektromagnetische Strahlung, beispielsweise Licht, Infrarot- oder Ultraviolettstrahlung, in die Detektorvorrichtung eintritt und zu der aktiven Schicht geführt wird. In der aktiven Schicht wird unter Einwirkung der Strahlung ein Exziton angeregt, das in einem elektrischen Feld in ein Elektron und ein Loch aufgeteilt wird. So wird ein elektrisches Signal oder eine elektrische Ladung erzeugt und an den Elektroden bereitgestellt.

In allen Fällen ist eine hohe Effizienz der Umwandlung elektrischer Energie in elektromagnetische Strahlung bzw. für den umgekehrten Prozess wünschenswert. Der vorliegenden Erfindung liegt das Problem zugrunde, ein optoelektronisches Bauelement mit hoher Effizienz bereitzustellen.

Dieses Problem wird durch ein optoelektronisches Bauelement gemäß dem Patentanspruch 1 und durch die Verwendung eines Kupferkomplexes gemäß Patentanspruch 16 gelöst.

Weiterbildungen und vorteilhafte Ausgestaltungen des optoelektronischen Bauelements sind in den abhängigen Patentansprüchen angegeben.

### BEISPIELHAFTE AUSFÜHRUNGSFORMEN

Die verschiedenen Ausgestaltungen der nachfolgend beschriebenen Ausführungsformen gelten in gleicher Weise, soweit analog anwendbar, für das elektronische Bauelement und für die Verwendung des Kupferkomplexes in einer organischen Schichtstruktur.

Verschiedene Ausführungsformen des optoelektronischen Bauelements haben eine organischen Schichtstruktur zum Trennen von Ladungsträgern eines ersten Ladungsträgertyps und Ladungsträgern eines zweiten Ladungsträgertyps. Die organische Schichtstruktur weist einen Kupferkomplex mit wenigstens einem Liganden mit der chemischen Struktur gemäß Formel I auf: 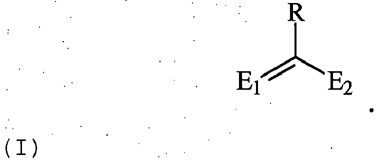 E₁ und E₂ sind jeweils unabhängig voneinander eines der folgenden Elemente: Sauerstoff, Schwefel oder Selen. R ist ausgewählt aus der Gruppe: Wasserstoff oder substituierte oder unsubstituierte, verzweigte, lineare oder zyklische Kohlenwasserstoffe.

Die organische Schichtstruktur ist dabei zum Trennen von Ladungsträgern eines ersten Ladungsträgertyps von Ladungsträgern eines zweiten Ladungsträgertyps eingerichtet. Beispielsweise handelt es sich bei den Ladungsträgern des ersten Ladungsträgertyps um Löcher und bei den Ladungsträgern des zweiten Ladungsträgertyps um Elektronen. Ein Beispiel für eine solche Schichtstruktur ist eine Ladungserzeugungsschichtfolge bzw. "*charge generating layer*" (*CGL*).

Eine solche Ladungserzeugungsschichtfolge weist eine p-dotierte Schicht auf, die den oben bezeichneten Kupferkomplex als p-Dotierstoff enthält. Die p-dotierte Schicht kann über eine Potentialbarriere, bspw. in Form einer Grenzschicht oder einer isolierenden Zwischenschicht, mit einer n-dotierten Schicht verbunden sein. Der Kupferkomplex weist eine sehr gute Dotierfähigkeit auf. Er verbessert einen Ladungsträgertransport in der Ladungserzeugungsschicht, insbesondere wird die Leitfähigkeit von Löchern in dem p-dotierten Bereich erhöht. Durch die hohen Leit- und Dotierfähigkeiten kann eine starke Bandverbiegung in der p-dotierten Schicht in Nähe der Potentialbarriere erreicht werden. Tunnelprozesse von Ladungsträgern durch die Potentialbarriere können so verbessert werden. Durch die hohe Leitfähigkeit werden durch einen Tunnelprozess transferierte Ladungsträger leicht aus der Ladungserzeugungsschichtfolge transportiert. Insgesamt kann so die Ladungserzeugungsschichtfolge eine hohe Anzahl frei beweglicher Ladungsträger bereitstellen, wodurch eine besonders hohe Effizienz des optoelektronischen Bauelements erreicht wird.

Ein weiterer Vorteil der Verwendung von Kupferkomplexen ist die leichte Verfügbarkeit der Ausgangsstoffe und die gefahrlose Verarbeitung der Dotierstoffe, so dass eine kostengünstige und umweltschonende Alternative zu bereits bekannten Dotierstoffen genutzt werden kann.

In einigen Ausführungsformen ist der Kupferkomplex ein Kupfer (I) penta-Fluor-Benzoat. Dieses weist die folgende Struktur auf: 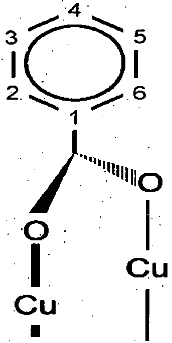 wobei die Positionen 2 bis 6 durch eine Fluorierung besetzt sind. Die Auswahl des Kupfer(I)penta-Fluor-Benzoats ist vor allem deswegen vorteilhaft, weil mit diesem Komplex eine hohe Löcher-Leitfähigkeit und eine geringe Absorption im sichtbaren Spektralbereich verbunden ist. Für eine 100 nm dicke Schicht aus (4,4',4" -tris(N-(1-naphthyl)-N-phenyl-amino)Triphenylamin, das mit Kupfer(I)penta-Fluor-Benzoat dotiert wurde, konnte eine Transmission von mehr als 93% oberhalb einer Wellenlänge von 420nm gemessen werden.

Weiterhin ist Kupfer(I)penta-Fluor-Benzoat besonders für eine Verarbeitung bei der Herstellung eines optoelektronischen Bauelements geeignet. Es hat eine Verdampfungstemperatur von lediglich ca. 200°C. Andere für eine p-Dotierung verwendete Dotierstoffe, wie V₂O₅, MoO₃ WO₃ oder F4-TCNQ(2,3,5,6-Tetrafluoro-7,7,8,8-Tetracyanoquinodimethan) weisen eine wesentlich höhere Verdampfungstemperatur auf. Kupfer(I)penta-Fluor-Benzoat kann daher ohne die Verwendung besonderer Hochtemperatur-Verdampfungsquellen verarbeitet werden.

In einigen Ausführungsformen weist die p-dotierte organische Halbleiterschicht einen Dotierungsgradienten hin zu der n-dotierten organische Halbleiterschicht auf. Das bedeutet, dass die Konzentration des Dotierstoffes sich über den Querschnitt der p-dotierten organischen Halbleiterschicht verändert. Vorteilhafterweise nimmt die Dotierung der p-dotierten organische Halbleiterschicht hin zu der n-dotierten organischen Halbleiterschicht zu. Damit wird eine Beweglichkeit von Löchern in der p-dotierten organischen Halbleiterschicht gerade im Bereich der Grenzfläche der n-dotierten organische Halbleiterschicht bzw. der Zwischenschicht erhöht. Dies ist für einen Abtransport von Ladungsträgern in diesem Bereich von besonderem Vorteil. Zusätzlich kann so eine Potentialbarriere an der Grenzfläche bzw. der Zwischenschicht besonders effizient gestaltet werden. Ein Dotiergradient kann dabei beispielsweise durch das Aufbringen mehrerer p-dotierter organischer Halbleiterschichten übereinander erzielt werden. Ebenso ist es denkbar, dass während eines Herstellprozesses der p-dotierten Halbleiterschicht die Zufuhr des Dotierstoffes durch einen geeigneten Prozess verändert wird, so dass mit zunehmender Schichtdicke eine andere Dotierung der Schicht erfolgt. Die Dotierstoffkonzentration kann beispielsweise von 0% an der Grenzfläche bzw. der Zwischenschicht abgewandten Seite bis 100% an der Grenzfläche bzw. der Zwischenschicht zugewandten Seite verlaufen. In diesem Fall ist an der Grenzfläche/Zwischenschicht ein dünner Dotierstofffilm denkbar. Es ist zusätzlich denkbar, dass unterschiedliche Dotierstoffe in der p-dotierten Halbleiterschicht eingebracht sind, und dass so eine Variation in der Leitfähigkeit oder eine geeignete Gestaltung der Potentialbarriere bewirkt wird.

In verschiedenen Ausführungsformen weist das optoelektronische Bauelement einen die organische Schichtstruktur umfassenden Schichtstapel auf. Dabei kann der Schichtstapel wenigstens eine aktive Schicht aufweisen. Die aktive Schicht weist beispielsweise ein elektrolumineszentes Material auf. Das optoelektronische Bauelement ist damit als strahlungsemittierende Vorrichtung ausgestaltet. In verschiedenen Ausführungsformen ist die organische Schichtstruktur zwischen einer ersten aktiven Schicht und einer zweiten aktiven Schicht angeordnet. Die organische Schichtstruktur hat insbesondere die Funktion, den aktiven Schichten intrinsische Ladungsträger bereitzustellen. In verschiedenen Ausführungsformen ist die organische Schichtstruktur auf einer Elektrode, insbesondere einem Anodenkontakt, aufgebracht. Dabei unterstützt die organische Schichtstruktur in vorteilhafter Weise einen Übertritt von positiven Ladungsträgern aus dem Anodenmaterial in organische Halbleiterschichten.

### KURZE BESCHREIBUNG DER ZEICHNUNGEN'

Verschiedene Ausführungsbeispiele des optoelektronischen Bauelements werden im Folgenden anhand der Zeichnungen näher erläutert. In den Figuren geben die erste(n) Ziffer(n) eines Bezugszeichens die Figur an, in denen das Bezugzeichen zuerst verwendet wird. Die gleichen Bezugszeichen werden für gleichartige oder gleich wirkende Elemente bzw. Eigenschaften in allen Figuren verwendet. Es zeigen:
- **Fig.1a**: eine schematische Darstellung eines ersten Ausführungsbeispiels einer Ladungserzeugungsschicht;
- **Fig.1b**: eine schematische Darstellung eines zweiten Ausführungsbeispiels einer Ladungserzeugungsschicht;
- **Fig.2a**: eine schematische Darstellung der Energieniveaus in einer Ladungserzeugungsschichtfolge ohne angelegter Spannung;
- **Fig.2b**: eine schematische Darstellung der Energieniveaus in der Ladungserzeugungsschichtfolge mit angelegter Sperrspannung;
- **Fig.3**: eine schematische Darstellung eines ersten Ausführungsbeispiels eines optoelektronischen Bauelements;
- **Fig.4**: eine schematische Darstellung eines zweiten Ausführungsbeispiels eines optoelektronischen Bauelements und
- **Fig.5**: eine schematische Darstellung eines dritten Ausführungsbeispiels eines optoelektronischen Bauelements.

### LADUNGSERZEUGUNGSSSCHICHTFOLGE

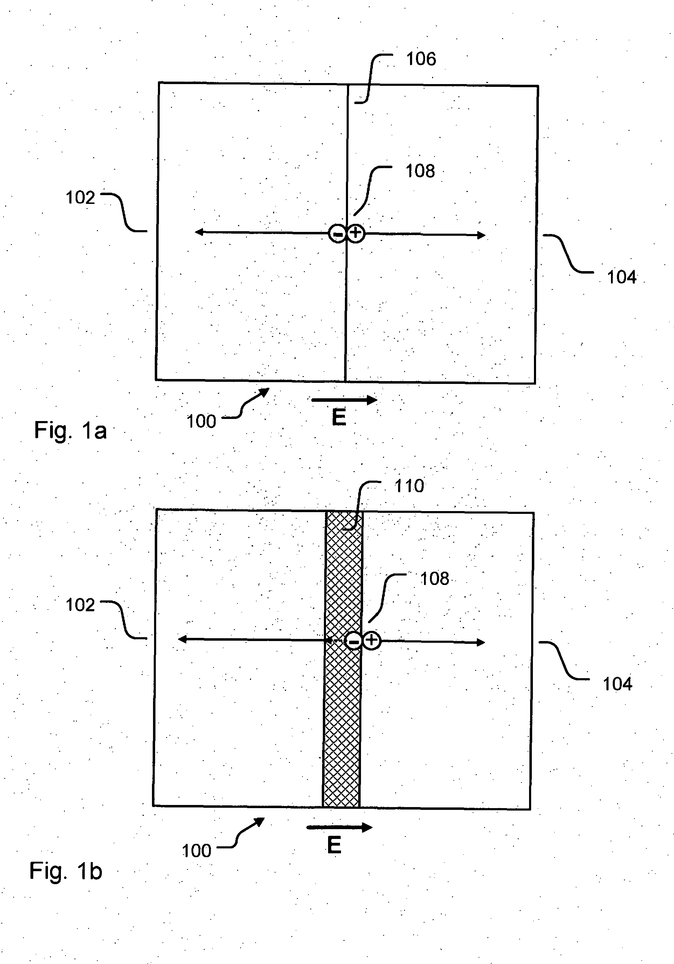

**Fig.1a** und **Fig. 1b** zeigen eine schematische Darstellung eines ersten bzw. zweiten Ausführungsbeispiels einer Ladungserzeugungsschichtfolge 100.

Die Ladungserzeugungsschichtfolge 100 weist in unterschiedlichen Ausgestaltungen eine Schichtfolge von dotierten organischen und anorganischen Halbleitermaterialien auf. In dem in der **Fig. 1a** dargestellten ersten Ausführungsbeispiel ist die Ladungserzeugungsschichtfolge 100 als eine Schichtfolge einer n-dotierten ersten organischen Halbleiterschicht 102 und einer p-dotierten zweiten organischen Halbleiterschicht 104 ausgestaltet. Zwischen der ersten organischen Halbleiterschicht 102 und der zweiten organischen Halbleiterschicht 104 ist eine Grenzfläche 106 ausgebildet.

An der Grenzfläche 106 der n-dotierten ersten organischen Halbleiterschicht 102 und der p-dotierten zweiten organischen Halbleiterschicht 104 bildet sich unter Anlegen eines elektrischen Feldes **E** eine Verarmungszone. Durch Quantenfluktuationen kann an der Grenzfläche 106 spontan ein Ladungsträgerpaar 108 entstehen. Das Ladungsträgerpaar 108 umfasst Ladungsträger unterschiedlichen Ladungsträgertyps, wie etwa ein Elektron und ein Loch. Das Elektron kann aus der p-dotierten zweiten organischen Halbleiterschicht 104 durch einen Tunnelprozess die Potentialbarriere der Grenzfläche 106 durchqueren und so einen freien Zustand in der n-dotierten Halbleiterschicht 102 besetzen. In der p-dotierten zweiten Halbleiterschicht 104 verbleibt zunächst ein unbesetzter Zustand in Form des Lochs. Man kann diese Fluktuation also derart beschreiben, dass an der Grenzfläche 106 spontan ein Ladungsträgerpaar 108 mit Ladungsträgern unterschiedlichen Ladungsträgertyps entsteht. Durch einen Tunnelprozess werden die Ladungsträger getrennt. Unter der Einwirkung des elektrischen Feldes **E** wandern die Ladungsträger je nach Ladungsträgertyp in Richtung der Anode bzw. der Kathode. Eine Rekombination der Ladungsträger wird somit durch den von dem elektrischen Feld **E** bewirkten Ladungsträgertransport zu den Elektroden vermieden.

In dem in **Fig. 1b** dargestellten zweiten Ausführungsbeispiel ist zwischen der ersten organischen Halbleiterschicht 102 und der zweiten organischen Halbleiterschicht eine geeignete Zwischenschicht 110 (*interlayer*) als Potentialbarriere angeordnet. Die Zwischenschicht 110 weist beispielsweise ein Material wie CuPc (Kupferphtalocyanin) auf. Mit Hilfe der Zwischenschicht 110 kann die Ladungserzeugungsschichtfolge 100 hinsichtlich der Spannungsfestigkeit stabilisiert werden. Weiterhin kann mittels der Zwischenschicht 110 verhindert werden, dass es zu einer Diffusion von Dotierstoffen von einer organischen Halbleiterschicht in die andere oder zu einer chemischen Reaktion zwischen beiden organischen Halbleiterschichten bzw. deren Dotierstoffen kommt. Schließlich kann mittels der Zwischenschicht 110 die Potentialbarriere, insbesondere die Breite der Potentialbarriere, zwischen der n-dotierten organischen Halbleiterschicht 102 und der p-dotierten organischen Halbleiterschicht 104 gestaltet werden. Damit kann beispielweise die Stärke eines durch Quantenfluktuationen entstehenden Tunnelstroms beeinflusst werden.

### ENERGIENIVEAUS IN DER LADUNGSERZEUGUNGSSCHICHTFOLGE

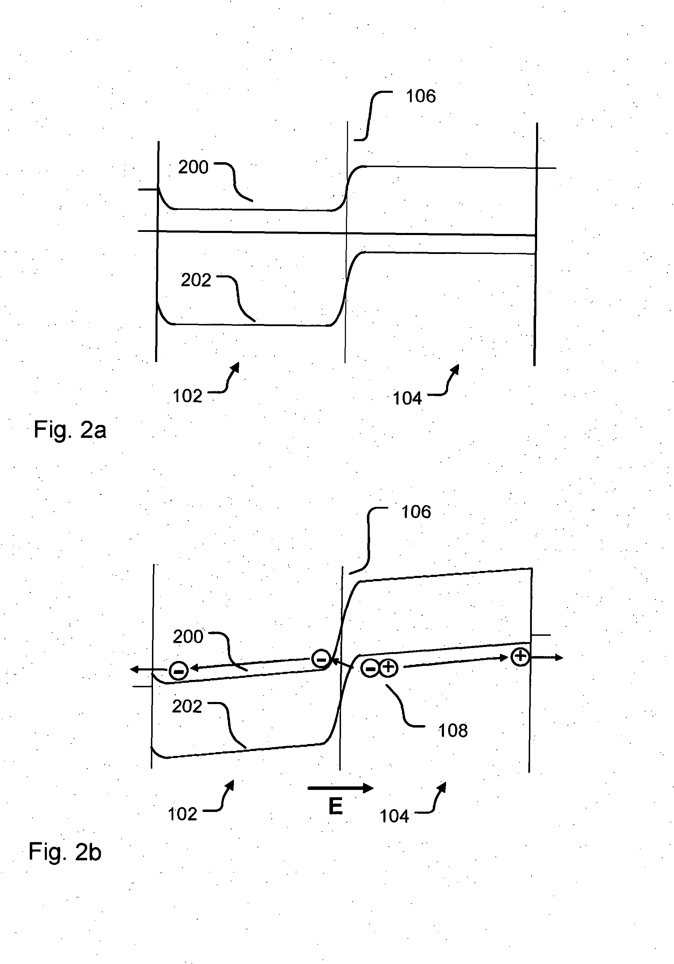

**Fig. 2a** zeigt eine schematische Darstellung der Energieniveaus in der Ladungserzeugungsschichtfolge 100 ohne angelegte Spannung. Die Ladungserzeugungsschichtfolge 100 weist eine n-dotierte erste organische Halbleiterschicht 102 und eine p-dotierte zweite organische Halbleiterschicht 104 auf. Der Ladungstransport in organischen Halbleitern findet im wesentlichen durch hopping-Prozesse von einem lokalisierten Zustand zu einem benachbarten ebenfalls lokalisierten Zustand statt. Dargestellt sind in der **Fig. 2a** die Energieniveaus in der ersten organischen Halbleiterschicht 102 und der zweiten organischen Halbleiterschicht 104. Angegeben sind jeweils das *Lowest Unoccupied Molecular Orbital* (LUMO)-Energieniveau 200 und das *Highest Occupied Molecular Orbital* (HOMO)-Energieniveau 202 der ersten organischen Halbleiterschicht 102 und der zweiten organischen Halbleiterschicht 104. Das LUMO-Energieniveau 200 ist dem Leitungsband eines anorganischen Halbleiters vergleichbar und gibt den Energiebereich an, in dem Elektronen eine sehr hohe Beweglichkeit aufweisen. Das HOMO-Energieniveau 202 ist dem Valenzband eines anorganischen Halbleiters vergleichbar und gibt den Energiebereich an, in dem Löcher eine sehr hohe Beweglichkeit aufweisen. Zwischen dem LUMO-Energieniveau und dem HOMO-Energieniveau bildet sich eine Energielücke, die einem Bandabstand (*band gap*) in einem anorganischen Halbleiter entsprechen würde.

Die erste organische Halbleiterschicht 102 ist n-dotiert, während die zweite organische Halbleiterschicht 104 p-dotiert ist. Entsprechend weist die erste organische Halbleiterschicht 102 ein niedrigeres LUMO-Energieniveau und ein niedrigeres HOMO-Energieniveau als die zweite organische Halbleiterschicht 104 auf. An der Grenzfläche 106 gehen die Energieniveaus durch freie Ladungsträger oder mögliche Dipolbildungen kontinuierlich ineinander über. Es kommt zu einer Bandverbiegung an der Grenzfläche 106.

**Fig. 2b** zeigt eine schematische Darstellung der Energieniveaus in der Ladungserzeugungsschichtfolge 100 bei einer angelegten Sperrspannung. Die Sperrspannung ist mit einem elektrischen Feld **E** verbunden. Aufgrund der Sperrspannung verschieben sich die Energieniveaus in den organischen Halbleiterschichten, indem sie aufgrund des Spannungsabfalls über die Ladungserzeugungsschichtfolge 100 geneigt werden. An der Grenzfläche 106 entsteht so ein Bereich, in dem das LUMO-Energieniveau 200 der ersten organischen Halbleiterschicht 102 gleiche Werte annimmt wie das HOMO-Energieniveau 202 der zweiten organischen Halbleiterschicht 104. Durch Quantenfluktuationen kann sich in dem HOMO-Energieniveau 202 der zweiten organischen Halbleiterschicht 104 ein Ladungsträgerpaar 108 an der Grenzfläche 106 bilden. Das Ladungsträgerpaar 108 besteht aus einem Elektron und einem Loch. Durch die Bandverbiegung an der Grenzfläche 106 kann das Elektron mit einer relativ hohen Wahrscheinlichkeit in einem Tunnelprozess die Potentialbarriere an der Grenzfläche 106 durchqueren und einen freien Zustand in dem LUMO-Energieniveau 200 der n-dotierten ersten organischen Halbleiterschicht 102 einnehmen.

Das verbleibende Loch wird durch das elektrische Feld **E** von der Grenzschicht 106 weg aus der zweiten organischen Halbleiterschicht 104 transportiert. Das Elektron in der ersten organischen Halbleiterschicht wird durch das abfallende LUMO-Energieniveau 200 von der Grenzschicht wegtransportiert. Im Ergebnis werden unter Anlegen einer Sperrspannung aufgrund intrinsischer Anregungen an der Ladungserzeugungsschichtfolge 100 zusätzliche freie Ladungsträger bereitgestellt.

Es ist denkbar, dass zur Erhöhung oder Ausgestaltung des Tunnelstroms zwischen der ersten organischen Halbleiterschicht 102 und der zweiten organischen Halbleiterschicht eine geeignete Zwischenschicht 110 (*interlayer*) als Potentialbarriere angeordnet ist. Die Zwischenschicht 110 weist beispielsweise ein Material wie CuPc (Kupferphtalocyanin) auf. Mithilfe der Zwischenschicht 110 kann die Ladungserzeugungsschichtfolge 100 hinsichtlich der Spannungsfestigkeit stabilisiert werden. Weiterhin kann mittels der Zwischenschicht verhindert werden, dass es zu einer Diffusion von Dotierstoffen von einer organischen Halbleiterschicht in die andere oder zu einer chemischen Reaktion zwischen beiden organischen Halbleiterschichten bzw. deren Dotierstoffen kommt. Schließlich kann mittels der Zwischenschicht die Potentialbarriere, insbesondere die Breite der Potentialbarriere, zwischen der n-dotierten organischen Halbleiterschicht 102 und der p-dotierten organischen Halbleiterschicht 104 gestaltet werden. Damit kann beispielweise die Stärke eines durch Quantenfluktuationen entstehenden Tunnelstroms beeinflusst werden.

Wegen der beschriebenen Funktion der Ladungserzeugungsschichtfolge 100 kann diese auch als organische Schicht zum Trennen von Ladungsträgern bezeichnet werden, bzw. als *CGL.* Untersuchungen zu der Ladungserzeugungsschichtfolge 100 sind beispielsweise aus dem Dokument [1] und dem Dokument [2] bekannt.

US 2005/260451 A1 (KIJIMA YASUNORI [JP]) 24. November 2005 (2005-11-24) offenbart ein Bauelement mit einer organischen Schichtstruktur zum Trennen von Ladungsträgern.

EP 1 351 558 A1 (KIDO JUNJI [JP]; INTERNAT MFG AND ENGINEERING S [JP] KIDO JUNJI [JP];) 8. Oktober 2003 (2003-10-08) offenbart auch ein organisches Bauelement.

YULIA SEVRYUGINA ET AL: "Tetranuclear copper(i) clusters: impact of bridging carboxylate ligands on solid state structure and photoluminescence", Chem. Commun., 2007, 3853-3855, offenbart Kupferkomplexe mit Liganden der Formel I und deren Photolumineszenz Spektren.

SEVRYUGINA ET AL: "X-ray structure and photoluminescence of copper(I) 2,6-bis(trifluoromethyl)benzoate", Inorg. Chim. Acta, 2007, 360, 3103-3107, offenbart einen Kupferkomplex mit Liganden der Formel I und dessen Röntgenstruktur.

SHARMA R P ET AL: "Segregated aromatic π-π stacking interactions involving fluorinated and non-fluorinated benzene rings: Cu(py)2 (pfb)2 and Cu(py)2 (pfb)2 (H2 O) (py=pyridine and pfb=pentafluorobenzoate)", J. Fluor. Chem., 2010, 131, 456-460, offenbart auch Kupferkomplexe mit Liganden der Formel I und deren Röntgenstrukturen.

Die erste organische Halbleiterschicht 102 ist n-dotiert. Für die n-Dotierung können Metalle mit geringer Austrittsarbeit, beispielsweise Cäsium, Lithium oder Magnesium verwendet werden. Ebenfalls sind Verbindungen als n-Dotierstoff geeignet, die diese Metalle enthalten, so beispielsweise Cs₂CO₃, CsF oder LiF. Diese Dotierstoffe sind in ein Matrixmaterial eingebracht. Als Matrixmaterial ist beispielsweise TPBi(1,3,5-Tris(1-phenyl-1H-benzimidazol-2-yl)Benzen) geeignet. Die zweite organische Halbleiterschicht 104 ist mit einem Kupferkomplex p-dotiert. Dabei können die folgenden Materialien als Teil des Matrixmaterials verwendet werden:
NPB (N,N'-bis(1-naphthyl)-N,N'-bis(phenyl)-Benzidin, β-NPB (N,N'-bis(naphthalen-2-yl)-N,N'-bis(phenyl)-Benzidin), TPD (N,N'-bis(3-methylphenyl)-N,N'-bis(phenyl)-Benzidin), N,N'-bis(1-naphthyl)-N,N'-bis(phenyl)-2,2-Dimethylbenzidin, Spiro-TPD (N,N'-bis(3-methylphenyl)-N,N'-bis(phenyl)-9,9-Spirobifluoren), Spiro-NPB (N,N'-bis(1-naphthyl)-N,N'-bis(phenyl)-9,9-Spirobifluoren), DMFL-TPD (N,N'-bis(3-methylphenyl)-N,N'-bis(phenyl)-9,9-Dimethylfluoren, DMFL-NPB (N,N'-bis(1-naphthyl)-N,N'-bis(phenyl)-9,9-Dimethylfluoren), DPFL-TPD (N,N'-bis(3-methylphenyl)-N,N'-bis(phenyl)-9,9-Diphenylfluoren), DPFL-NPB (N,N'-bis(naphth-1-yl)-N,N'-bis(phenyl)-9,9-Diphenylfluoren), Sp-TAD (2,2',7,7'-tetrakis(n,n-diphenylamino)-9,9'-Spirobifluoren), TAPC (di-[4-(N,N-ditolyl-amino)-phenyl]Cyclohexan), Spiro-TTB (2,2',7,7'-tetra(N, N-di-tolyl)Amino-Spiro-Bifluoren), BPAPF (9,9-bis[4-(N,N-bis-biphenyl-4-yl-amino)phenyl]-9H-Fluoren), Spiro-2NPB (2,2',7,7'-tetrakis[N-naphthyl(phenyl)-amino]-9,9-Spirobifluoren), Spiro-5 (2,7-bis[N,N-bis(9,9-spiro-bifluoren-2-yl)-amino]-9,9-Spirobifluoren), 2,2'-Spiro-DBP (2,2'-bis[N,N-bis(biphenyl-4-yl)amino]-9,9-Spirobifluoren), PAPB (N, N'-bis(phenanthren-9-yl)-N,N'-bis(phenyl)-Benzidin), TNB (N, N,N',N'-tetra-naphthalen-2-yl-Benzidin), Spiro-BPA (2,2'-bis (N,N-di-phenyl-amino)-9,9-Spirobifluoren), NPAPF (9,9-Bis[4-(N,N-bis-naphthyl-amino)phenyl]-9H-Fluoren), NPBAPF (9,9-bis[4-(N, N'-bis-naphth-2-yl-N,N'-bis-phenyl-amino)-phenyl]-9H-Fluoren), TiOPC (Titanoxid-Phthalocyanin), CuPC (Kupferphthalocyanin), F4-TCNQ (2,3,5,6-tetrafluor-7,7,8,8,-tetracyano-Quinodimethan), m-MTDATA (4,4',4" -tris(N-3-methylphenyl-N-phenyl-amino)Triphenylamin), 2T-NATA (4,4',4"-tris(N-(naphthalen-2-yl)-N-phenyl-amino)Triphenylamin), 1-TNATA (4,4',4" -tris(N-(1-naphthyl)-N-phenyl-amino)Triphenylamin), NATA (4,4',4" -tris(N,N-diphenyl-amino)Triphenylamin), PPDN (pyrazino[2,3-f][1,10]phenanthrolin-2,3-Dicarbonitril), MeO-TPD (N, N, N' ,N' -tetrakis(4-methoxyphenyl)-Benzidin), MeO-Spiro-TPD (2,7-bis[N,N-bis(4-methoxy-phenyl)amino]-9,9-Spirobifluoren), 2,2'-MeO-Spiro-TPD (2,2'-bis[N,N-bis(4-methoxy-phenyl)amino]-9,9-Spirobifluoren), β-NPP (N, N'-di(naphthalen-2-yl)-N,N'-diphenylbenzen-1,4-Diamin), NTNPB (N,N'-di-phenyl-N,N'-di-[4-(N, N-di-tolyl-amino)phenyl]-Benzidin) oder NPNPB (N,N'-di-phenyl-N,N'-di-[4-(N, N-di-phenyl-amino)phenyl]-Benzidin).

Als p-Dotierstoff dient ein Kupferkomplex mit wenigstens einem Liganden mit der chemischen Struktur gemäß Formel I:

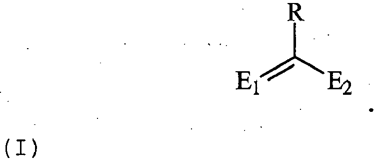

E₁ und E₂ sind jeweils unabhängig voneinander eines der folgenden Elemente: Sauerstoff, Schwefel oder Selen. R ist ausgewählt aus der Gruppe: Wasserstoff oder substituierte oder unsubstituierte, verzweigte, lineare oder zyklische Kohlenwasserstoffe.

Der oben genannte Kupferkomplex ist im Verhältnis zu dem Matrixmaterial der zweiten organischen Halbleiterschicht 104 ein metallo-organischer Akzeptorverbund. Er dient als p-Dotierstoff. Dabei kann der Kupferkomplex ein isoliertes Molekül sein. Häufig wird der Kupferkomplex über chemische Bindungen mit Molekülen des Matrixmaterials verbunden sein, beispielsweise indem Moleküle des Matrixmaterials als Liganden einen Teil des Kupferkomplexes bilden. Üblicherweise komplexiert das Kupferatom mit organischen Liganden. Die organischen Liganden können geeignete funktionelle Gruppen bilden, so dass eine Verbindung zu einem Oligomer oder einem Polymer ermöglicht ist.

Der Kupferkomplex kann einen einzähnigen, dreizähnigen oder einen vierzähnigen Liganden aufweisen. Insbesondere kann er eine oder mehrere Gruppen C(=E₁)E₂ enthalten, wobei wenigstens eins oder mehrere der Donatoratome E₁ und E₂ der Liganden und die Kupferatome komplexieren. Die C(=E₁)E₂-Gruppe weist dabei üblicherweise eine negative Ladung auf. Ebenso können auch nicht-deprotonierte Carboxylsäuren oder Homologe von diesen als Liganden des Kupferkomplexes dienen. Allgemein trägt der Ligand des Kupferkomplexes negative Ladung in den Komplex bei, beispielsweise durch eine negative Ladung pro Carboxylgruppe bzw. pro homologer Carboxylgruppe.

Soweit sich keine Moleküle des Matrixmaterials mit den Kupferatomen verbinden, ist der Kupferkomplex ein homoleptischer Komplex, bei dem allein Liganden mit dem zentralen Kupferatom komplexieren. Oft weist ein solcher Komplex eine rechteckige oder lineare Molekülgeometrie auf. Dies gilt besonders, wenn Wechselwirkungen zwischen Kupferatomen vernachlässigbar sind. Soweit Moleküle aus dem Matrixmaterial mit dem zentralen Kupferatom verbinden, nimmt die Molekülgeometrie des Komplexes die Form einer pentagonalen Bipyramide an oder der Komplex erhält eine quadratisch-pyramidiale Molekülgeometrie. Dabei ist der Kupferkomplex gewöhnlich ein elektrisch neutraler Komplex.

Der Kupferkomplex kann sowohl ein mononuklearer Kupferkomplex als auch ein polynuklearer Kupferkomplex sein. In einem polynuklearen Kupferkomplex kann der Ligand lediglich mit einem Kupferatom oder mit zwei Kupferatomen verbunden sein. Dabei kann der Ligand beispielsweise eine Brücke zwischen zwei Kupferatomen bilden. Sollte der Ligand drei- oder mehrzählig sein, kann er auch mehr Kupferatome als Brücke verbinden. Im Fall eines polynuklearen Kupferkomplexes können Kupfer-Kupfer-Verbindungen zwischen zwei oder mehreren Kupferatomen bestehen. Die Verwendung polynuklearer Kupferkomplexe ist deswegen besonders vorteilhaft, weil eine derart dotierte organische Funktionsschicht eine höhere Lebensdauer als eine mit einem mononuklearen Kupferkomplex dotierte Funktionsschicht aufweist. Dies kann durch eine Destabilisierung des Komplexes bei einem Ladungstransport durch die Funktionsschicht erklärt werden. Die Wirkung des Ladungstransports wird im Fall polynuklearer Kupferkomplexe nicht nur auf ein sondern auf mehrere Kupferkomplexe verteilt.

Ein polynuklearer Kupferkomplex kann eine sogenannte "*paddel*-*wheel*/Schaufelrad"-Struktur aufweisen. Dies gilt insbesondere im Fall eines Kupfer(II)-Komplexes. Üblicherweise wird eine Schaufelrad-Struktur in einem Komplex mit zwei Metallatomen angenommen, wobei zwei Kupferatome mit einem oder mehr mehrzähligen Liganden als Brücke verbunden sind.

Häufig ist der Koordinationsmodus aller Liganden hinsichtlich des Kupferatoms fast identisch. Damit wird hinsichtlich der Kupferatome und der Liganden wenigstens eine zweizählige oder vierzählige Drehachse durch zwei der Kupferatome des polynuklearen Kupferkomplexes definiert. Dabei weisen quadratisch-planare Komplexe oft eine wenigstens vierzählige Drehachse auf, während linear-koordinierte Komplexe häufig eine zweizählige Drehachse aufweisen.

Das Kupferatom eines mononuklearen Komplexes oder wenigstens ein Kupferatom eines polynuklearen Kupferkomplexes kann eine Oxidationsstufe +2 aufweisen. In solchen Komplexen sind die Liganden häufig in einer quadratisch-planaren Geometrie koordiniert. Weist das Kupferatom eine Oxidationsstufe +1 auf, ist das Kupferatom häufig linear koordiniert.

Kupferkomplexe mit einem Cu(II)-Atom weisen in aller Regel eine höhere Lochleitfähigkeit auf als Kupferkomplexe mit einem Cu(I)-Atom. Letztere haben eine abgeschlossene d¹⁰-Schale. Die Lochleitfähigkeit ist vorrangig durch die durch die Cu(I)-Atome entstehende Lewis-Säure verursacht. Cu(II)-Komplexe weisen dagegen eine nicht-aufgefüllte d⁹-Konfiguration auf, wodurch ein Oxidationsverhalten verursacht wird. Eine teilweise Oxidation erhöht die Lochdichte. Die Verwendung von Cu(I)-Komplexen kann jedoch vorteilhaft sein, weil Cu(I)-Komplexe häufig thermisch stabiler sind als korrespondierende Cu(II)-Komplexe.

Den beschriebenen Kupferkomplexen ist gemein, dass sie eine Lewis-Säure sind. Eine Lewis-Säure ist eine Verbindung, die als Elektronenpaar-Akzeptor wirkt. Das Verhalten der Kupferkomplexe als Lewis-Säure ist mit den Molekülen des Matrixmaterials verknüpft, in das der Kupferkomplex als Dotierstoff eingebracht ist. Die Moleküle des Matrixmaterials wirken in der Regel als Lewis-Base in Bezug auf die Lewissauren Kupfermoleküle. Eine Lewis-Base ist ein Elektronenpaar-Donator.

Das Kupferatom in dem Kupferkomplex besitzt eine offene, d.h. weitere Koordinationsstelle. An diese Koordinationsstelle kann sich eine Lewisbasische Verbindung binden, beispielsweise ein aromatisches Ringsystem, ein Stickstoffatom oder eine Aminkomponente, die in dem Matrixmaterial enthalten sind. Dies ist beispielhaft in den Abbildungen 1 und 2 dargestellt: 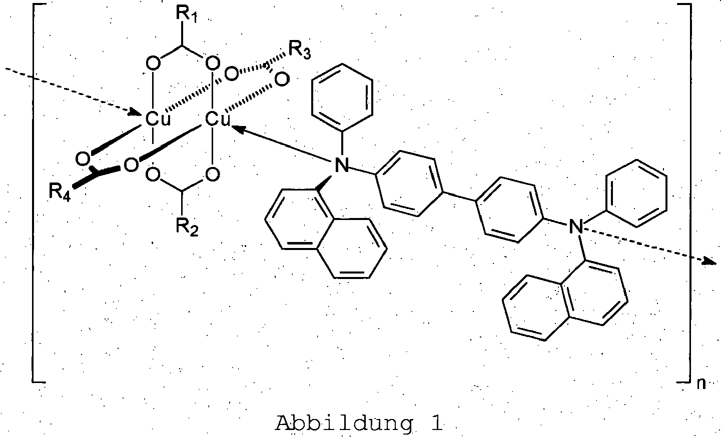 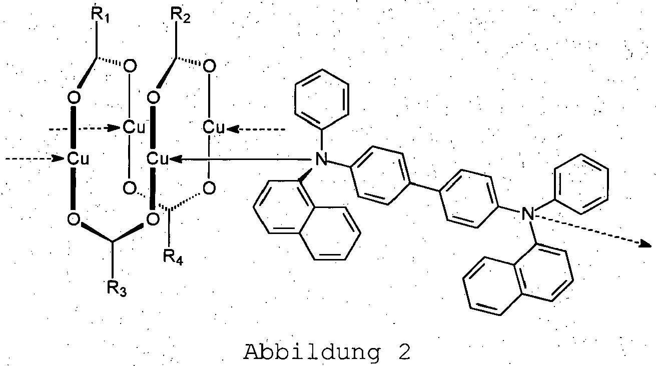 Es können auch Gruppen mit heteroaromatischen Ringsystemen oder ein Stickstoffatom einer Aminkomponente mit einem Kupferatom koordinieren.

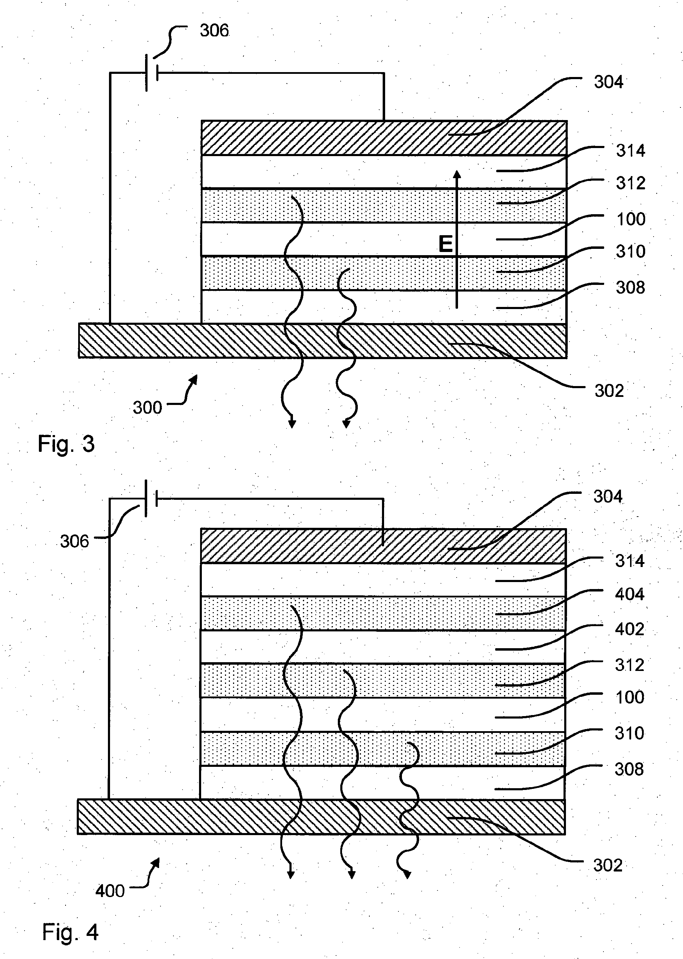

Der an das Kupferatom koordinierende Ligand kann eine Gruppe R aufweisen, die eine substituierte oder unsubstituierte Kohlenwasserstoffgruppe aufweist. Die Kohlenwasserstoffgruppe kann eine lineare, verzweigte oder zyklische Gruppe sein. Diese kann 1 - 20 Kohlenstoffe aufweisen. Beispielsweise ist sie eine Methyl- oder Ethylgruppe. Sie kann auch kondensierte Substituenten aufweisen, wie Decahydronaphthyl, Adamantyl, Cyclohexyl oder teilweise bzw. vollständig substituierte Alkylgruppen. Die substituierten oder unsubstituierten aromatischen Gruppen sind beispielsweise Phenyl, Biphenyl, Naphthyl, Phenanthryl, Benzyl oder ein heteroaromatischer Rest, beispielsweise ein substituierter oder unsubstituierter Rest, der aus den Heterozyklen der Abbildung 3 ausgewählt sein kann:

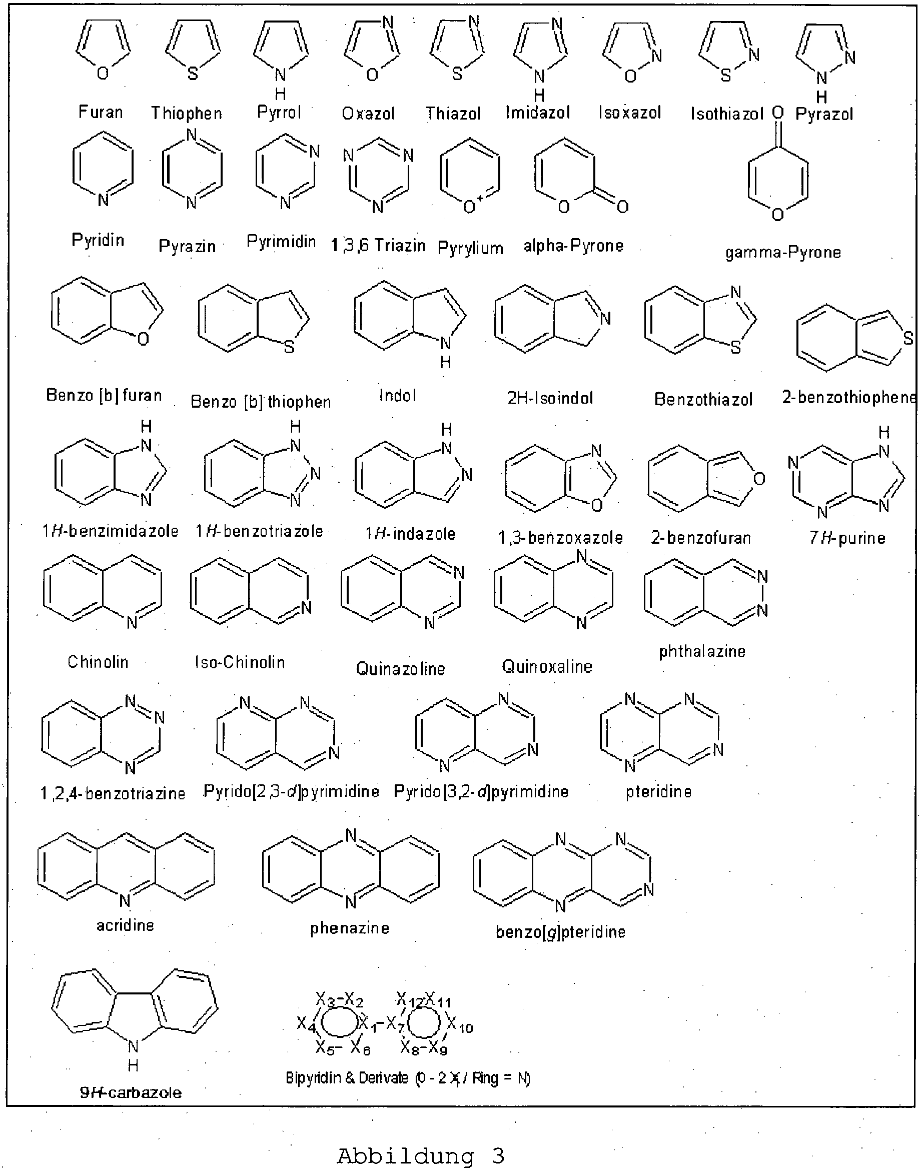

Der an das Kupferatom koordinierende Ligand kann auch eine Gruppe R aufweisen, die eine Alkyl- und/oder eine Arylgruppe umfasst. Die Alkyl- und/oder Arylgruppe enthält wenigstens einen elektronenentziehenden Substituenten. Der Kupferkomplex kann ebenfalls als gemischtes System eine oder mehrere Typen einer Carbonsäure enthalten

Ein elektronenentziehender Substituent wird in der vorliegenden Offenbarung als ein Substituent verstanden, der die Elektronendichte in einem an den Substituenten gebundenen Atom gegenüber einer Konfiguration erniedrigt, in der an Stelle des elektronenentziehenden Substituenten ein Wasserstoffatom an das Atom bindet.

Eine elektronenentziehende Gruppe kann beispielsweise aus der folgenden Gruppe ausgewählt sein: Halogene, wie Chlor oder insbesondere Fluor, Nitrogruppen, Cyanogruppen oder Mischungen dieser Gruppen. Die Alkyl- bzw. Arylgruppe können ausschließlich elektronenentziehende Substituenten, wie die genannten elektronenentziehenden Gruppen, oder Wasserstoffatome enthalten.

Wenn der Ligand eine Alkyl- und/oder Arylgruppe mit wenigstens einem elektronenentziehenden Substituenten aufweist, so wird die Elektronendichte an dem oder den Kupferatom(en) reduziert, wodurch der Lewis-Säuregrad des Komplexes erhöht wird.

Der Ligand kann dabei ein Anion der Kohlensäuren CHalₓH₃₋ₓCOOH, insbesondere CFₓH₃₋ₓCOOH und CClₓH₃₋ₓCOOH, repräsentieren, wobei Hal ein Halogenatom und x eine ganze Zahl von 0 bis 3 sind. Auch kann der Ligand ein Anion der Kohlensäuren CR'_{y}HalₓH_{3-x-y}COOH sein, wobei Hal ein Halogenatom, x eine ganze Zahl von 0 bis 3 und y eine ganze Zahl wenigstens mit dem Wert 1 ist. Die Restgruppe R' ist eine Alkylgruppe, ein Wasserstoffatom oder eine aromatische Gruppe, wie beispielsweise eine Phenylgruppe oder alle bisher beschriebenen Substituentengruppen. Sie kann elektronenentziehende Substituenten enthalten, insbesondere die weiter oben beschriebenen elektronenentziehenden Substituenten. Sie kann auch ein Derivat der Benzoesäure mit einem elektronenentziehenden Substituenten enthalten. Beispielsweise kann der Ligand ein Anion der Kohlensäure R'-(CF₂)ₙ-CO₂H sein, wobei n einen ganzzahligen Wert zwischen 1 und 20 annimmt. Beispielsweise kann eine fluorierte, insbesondere eine perfluorierte, homo- oder heteroaromatische Verbindung als Restgruppe verwendet werden. Ein Beispiel sind Anionen einer fluorierten Benzoesäure: 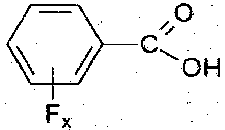 wobei x einen ganzahligen Wert von 1 bis 5 annimmt. Insbesondere können die folgenden Substituenten, bzw. solche bei denen Fluor durch Chlor ersetzt wurde, an die Carboxylgruppe binden, die alle starke Lewissäuren sind:

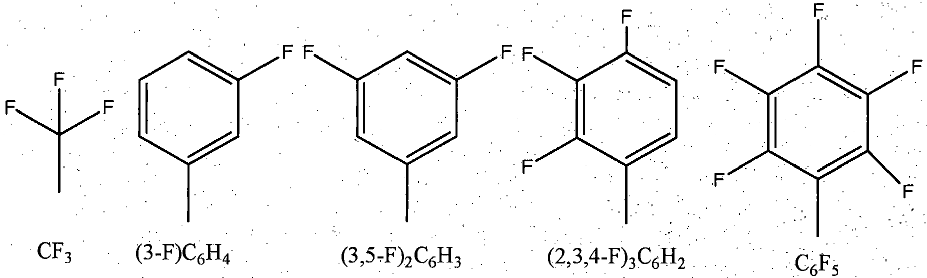

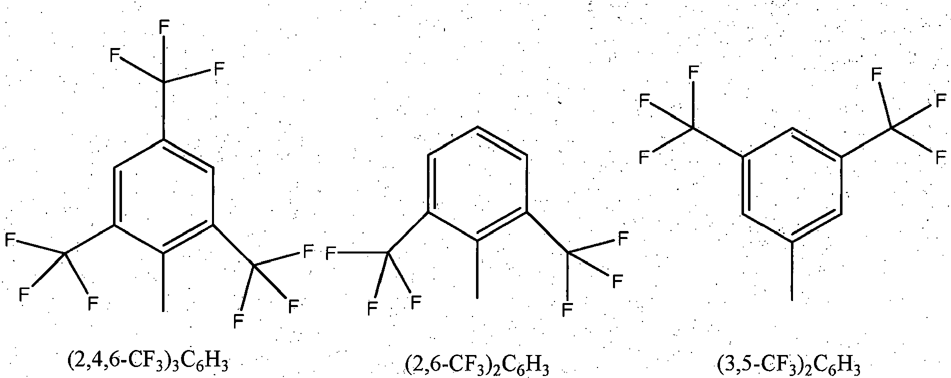

Weiterhin können Anionen der folgenden Säure als Liganden verwendet werden: 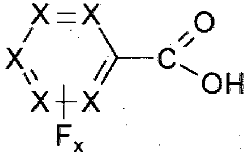 wobei X ein Stickstoff oder ein Kohlenstoffatom sein kann, das beispielsweise an ein Wasserstoffatom oder ein Fluoratom bindet. Beispielhaft können drei der Atome X für ein Stickstoffatom und zwei für eine C-F-Bindung oder C-H-Bindung (als Triazinderivate) stehen. Auch können Anionen der folgenden Säure als Liganden verwendet werden: 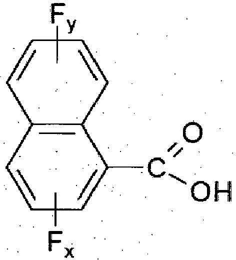 wobei der Naphtylring mit 1 bis 7 Fluorsubstituenten substituiert ist, so dass gilt y = 0 - 4 und x = 0 - 3, wobei y+x = 1 -7.

Fluor und Fluorverbindungen als elektronenentziehende Substituenten sind insbesondere deshalb vorteilhaft, weil Kupferkomplexe, die Fluoratome enthalten, bei einer Herstellung des optoelektronischen Bauelements leicht verdampft und in einer organischen Schicht abgelagert werden können. Als weitere oder alternative Substituentengruppe kann eine Trifluormethylgruppe genannt werden.

### ERSTES AUSFÜHRUNGSBEISPIEL DES OPTOELEKTRONISCHEN BAUELEMENTS

**Fig.3** zeigt die schematische Darstellung eines ersten Ausführungsbeispiels eines optoelektronischen Bauelements mit einer Ladungserzeugungsschichtfolge. Das optoelektronische Bauelement 300 weist eine Anode 302 und eine Kathode 304 auf. Die Anode 302 und die Kathode 304 dienen als Elektroden des optoelektronischen Bauelements 300. Sie sind mit einer externen Stromquelle 306 verbunden, beispielsweise mit einer Batterie oder mit einem Akkumulator. Zwischen der Anode 302 und der Kathode 304 ist ein Schichtstapel aus organischen und/oder anorganischen Halbleitermaterialien angeordnet. Die Anode 302 und die Kathode 304 weisen jeweils ein gut leitfähiges Material auf, das hinsichtlich seiner optischen Eigenschaften gewählt sein kann. Beispielsweise kann die Anode 302 und/oder die Kathode 304 aus einem transparenten Material bestehen, das ein Metalloxid, so wie ein Indiumzinnoxid (*Indium Tin Oxide* oder *ITO*), und/oder ein transparentes, leitfähiges Polymer enthält. Ebenso kann wenigstens eine der Anode 302 und der Kathode 304 aus einem hochleitfähigen, reflektierenden Material bestehen, das beispielsweise ein Metall, etwa Aluminium, Silber, Platin, Kupfer oder Gold, oder eine Metalllegierung enthält.

Über die Anode 302 werden positive Ladungsträger (Löcher) in den Schichtstapel injiziert, während über die Kathode 304 negative Ladungsträger (Elektronen) in den Schichtstapel injiziert werden. Gleichzeitig liegt zwischen der Anode 302 und der Kathode 304 ein elektrisches Feld **E** an. Das elektrische Feld E bewirkt, dass aus der Anode 302 injizierte Löcher durch den Schichtstapel in Richtung der Kathode 304 wandern. Aus der Kathode 304 injizierte Elektronen wandern unter Einfluss des elektrischen Feldes **E** in Richtung der Anode 302.

Der Schichtstapel weist eine Reihe unterschiedlicher funktioneller Schichten auf. Unmittelbar auf der Anode 302 ist eine lochtransportierende Schicht 308 aufgebracht. Auf der lochtransportierenden Schicht 308 ist eine erste aktive Schicht 310 aufgebracht. Die lochtransportierende Schicht 308 dient dem Transport von aus der Anode 302 injizierten Löcher in die erste aktive Schicht 310. Sie kann beispielsweise ein p-dotiertes leitfähiges organisches oder anorganisches Material aufweisen. Für die p-Dotierung kann jedes geeignetes Material verwendet werden. Beispielsweise dient als p-Dotierstoff ein Kupferkomplex mit wenigstens einem Liganden mit der chemischen Struktur gemäß Formel I:

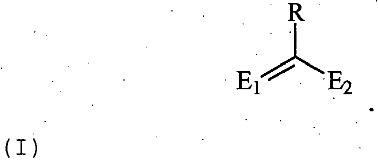

E₁ und E₂ sind jeweils unabhängig voneinander eines der folgenden Elemente: Sauerstoff, Schwefel oder Selen. R ist ausgewählt aus der Gruppe: Wasserstoff oder substituierte oder unsubstituierte, verzweigte, lineare oder zyklische Kohlenwasserstoffe.

Weil der Ladungsträgertransport in organischen Halbleitern nicht im Leitungsband sondern beispielsweise durch Hüpf- bzw. Tunnelprozesse erfolgt, kommt es zu erheblich verschiedenen Beweglichkeiten von Löchern und Elektronen. Damit eine Exzitonenbildung nicht in der Anode 302, sondern insbesondere in der ersten aktiven Schicht 310, stattfindet, kann weiterhin eine elektronentransport-blockierende Schicht zwischen Anode 302 und der ersten aktiven Schicht 310 vorgesehen sein.

Der Schichtstapel weist weiterhin eine zweite aktive Schicht 312 auf, die von der ersten aktiven Schicht 310 durch eine Ladungserzeugungsschichtfolge 100 getrennt ist. Die zweite aktive Schicht 312 ist von einer elektronentransportierende Schicht 314 und der darüber angeordneten Kathode 304 bedeckt. Die elektronentransportierende Schicht 314 dient dem Transport von aus der Kathode 304 injizierten Elektronen in eine zweite aktive Schicht 312. Sie kann beispielsweise ein n-dotiertes leitfähiges organisches oder anorganisches Material aufweisen.

Die Ladungserzeugungsschichtfolge 100 dient der Bereitstellung von zusätzlichen Ladungsträgern, indem sie Löcher in Richtung der Kathode 304 und Elektronen in Richtung der Anode 302 injiziert. Zwischen der Ladungserzeugungsschichtfolge 100 und der Anode 302 stehen der ersten aktiven Schicht 310 damit mehr Ladungsträger bereit. Ebenso werden der zweiten aktiven Schicht 312 mehr Ladungsträger bereitgestellt. Der Spannungsabfall über den Schichtstapel ist damit verringert. Dies hat zur Folge, dass auch bei geringen Spannungen, d.h. kleinen elektrischen Feldern im Schichtstapel, vergleichsweise hohe Ströme fließen können. Anhand des Beispiels einer OLED wird der damit verbundene Vorteil deutlich.

Im Beispiel der OLED sind sowohl die erste aktive Schicht 310 als auch die zweite aktive Schicht 312 lichtemittierende Schichten. Dazu weisen die erste aktive Schicht 310 und die zweite aktive Schicht 312 jeweils ein organisches Elektrolumineszenzmaterial auf, mittels dem die Bildung von Exzitonen aus Ladungsträgern und ein anschließender Zerfall unter Emission elektromagnetischer Strahlung hervorgerufen wird. Die Auswahl des Elektrolumineszenzmaterials ist ein sich fortlaufend weiterentwickelnder Bereich. Zu Beispielen für derartige organische Elektrolumineszenzmaterialien zählen:
- (i) Poly(p-phenylenvinylen) und seine Derivate, an verschiedenen Positionen an der Phenylengruppe substituiert;
- (ii) Poly(p-phenylenvinylen) und seine Derivate, an verschiedenen Positionen an der Vinylengruppe substituiert;
- (iii) Poly(p-phenylenvinylen) und seine Derivate, an verschiedenen Positionen an der Phenylenkomponente und auch an verschiedenen Positionen an der Vinylengruppe substituiert;
- (iv) Polyarylenvinylen, wobei es sich bei dem Arylen um solche Gruppen wie etwa Naphthalin, Anthracen, Furylen, Thienylen, Oxadiazol und dergleichen handeln kann;
- (v) Derivate von Polyarylenvinylen, wobei das Arylen wie in (iv) oben sein kann und zusätzlich Substituenten an verschiedenen Positionen an dem Arylen aufweisen kann;
- (vi) Derivate von Polyarylenvinylen, wobei das Arylen wie in (iv) oben sein kann und zusätzlich Substituenten an verschiedenen Positionen an dem Vinylen aufweisen kann;
- (vii) Derivate von Polyarylenvinylen, wobei das Arylen wie in (iv) oben sein kann und zusätzlich Substituenten an verschiedenen Positionen an dem Arylen und Substituenten an verschiedenen Positionen an dem Vinylen aufweisen kann;
- (viii) Copolymere von Arylen-Vinylen-Oligomeren wie etwa solche in (iv), (v), (vi) und (vii) mit nichtkonjugierten Oligomeren; und
- (ix) Poly(p-phenylen) und seine Derivate, an verschiedenen Positionen an der Phenylengruppen substituiert, einschließlich Leiterpolymerderivate wie etwa Poly(9,9-dialkylfluoren) und dergleichen;
- (x) Polyarylene, wobei es sich bei dem Arylen um solche Gruppen wie Naphthalin, Anthracen, Furylen, Thienylen, Oxadiazol und dergleichen handeln kann; und ihre an verschiedenen Positionen an der Arylengruppe substituierten Derivate;
- (xi) Copolymere von Oligoarylenen wie etwa solche in (x) mit nichtkonjugierten Oligomeren;
- (xii) Polychinolin und seine Derivate;
- (xiii) Copolymere von Polychinolin mit p-Phenylen, substituiert an dem Phenylen mit beispielsweise Alkyl- oder Alkoxygruppen, um Löslichkeit zu erhalten; und
- (xiv) Starre Stabpolymere wie etwa Poly(p-phenylen-2,6-benzobisthiazol), Poly(p-phenylen-2,6-benzobisoxazol), Poly(p-phenylen-2,6-benzimidazol) und ihre Derivate.

Zu anderen organischen emittierenden Polymeren wie etwa solchen, die Polyfluoren verwenden, zählen Polymere, die grünes, rotes, blaues oder weißes Licht emittieren, oder ihre Familien, Copolymere, Derivate oder deren Mischungen. Zu anderen Polymeren zählen Polyspirofluoren-artige Polymere.

Alternativ können anstatt Polymeren kleine organische Moleküle, die über Fluoreszenz oder über Phosphoreszenz emittieren, als die organische Elektrolumineszenzschicht dienen. Zu Beispielen für kleinmolekülige organische Elektrolumineszenzmaterialien zählen:
(i) Tris(8-hydroxychinolinato)aluminium, (Alq);
(ii) 1,3-Bis(N,N-dimethylaminophenyl)-1,3,4-oxidazol (OXD-8);
(iii) -Oxo-bis(2-methyl-8-chinolinato)aluminium;
(iv) Bis(2-methyl-8-hydroxychinolinato)aluminium;
(v) Bis(hydroxybenzochinolinato)beryllium (BeQ.sub.2);
(vi) Bis(diphenyl-vinyl)biphenylen (DPVBI); und
(vii) Arylamin-substituiertes Distyrylarylen (DSA-Amin).

Die erste aktive Schicht 310 und die zweite aktive Schicht 312 können jeweils eine weiß-emittierende Schicht sein. Das bedeutet, dass sowohl die erste aktive Schicht 310 als auch die zweite aktive Schicht 312 elektromagnetische Strahlung im gesamten sichtbaren Spektrum emittieren. Durch das Stapeln zweier aktiver Schichten braucht jede der ersten aktiven Schicht 310 und der zweiten aktiven Schicht 312 nur eine geringe Leuchtstärke, wobei trotzdem eine hohe Leuchtstärke des gesamten optoelektronischen Bauteils 300 erreicht wird. Dabei ist es besonderes vorteilhaft, dass die p-Dotierung der zwischen den aktiven Schichten angeordneten Ladungstransportschicht 100 eine hohe Transparenz im Bereich des sichtbaren Lichts aufweist. In Folge wird eine hohe Lichtausbeute aus dem optoelektronischen Bauteil erzielt.

Durch das Vorsehen der Ladungserzeugungsschichtfolge 100 wird durch die Injektion zusätzlicher Ladungsträger in die angrenzenden aktiven Schichten die Ladungsträgerdichte insgesamt erhöht. Prozesse, wie beispielsweise die Bildung oder die Dissoziation von Ladungsträgerpaaren oder Exzitonen, werden verstärkt. Da ein Teil der Ladungsträger in der Ladungserzeugungsschichtfolge 100, d.h. im optoelektronischen Bauelement 300 selber, bereitgestellt werden, kann eine geringe Stromdichte an der Anode 302 und der Kathode 304 erreicht werden.

Die erste aktive Schicht 310 und die zweite aktive Schicht 312 können auch in zueinander verschobenen Spektren elektromagnetische Strahlung emittieren. So kann beispielsweise die erste aktive Schicht 310 in einem blauem Farbspektrum Strahlung emittieren, während die zweite aktive Schicht 312 Strahlung in einem grünen und roten Farbspektrum emittiert. Jede andere gewünschte oder geeignete Aufteilung ist dabei denkbar. Vorteilhaft ist dabei insbesondere, dass eine Aufteilung nach unterschiedlichen physikalischen und chemischen Eigenschaften von Emittermaterialien getroffen werden kann. Beispielsweise kann ein oder mehrere fluoreszente Emittermaterialien in der ersten aktiven Schicht 310 eingebracht sein, während ein oder mehrere phosphoreszente Emittermaterialien in der zweiten aktiven Schicht 312 eingebracht sind. Durch die Anordnung der Ladungserzeugungsschichtfolge 100 wird bereits eine Trennung der Emittermaterialien erreicht. Durch das Trennen der Emissionsspektren der beiden aktiven Schichten kann insbesondere auch ein gewünschter Farbort des optoelektronischen Bauelements eingestellt werden.

Die Funktion der Ladungserzeugungsschichtfolge 100 kann anschaulich so beschrieben werden, dass sie mehrere einzelne OLEDs in Form der aktiven Schichten in Serie verbindet. Durch das intrinsische Bereitstellen von Ladungsträgern können mehrere Photonen pro aus den Photonen injizierten Ladungsträgerpaaren emittiert werden. Insgesamt ist so bei allen Ausführungen die Stromeffizienz, d.h. das Verhältnis von emittierter Strahlung zu eingebrachtem elektrischen Strom (*cd*/*A*) des opto elektronischen Bauelements 300 deutlich erhöht. Weil auch mit geringen Strömen in den Elektroden eine hohe Leuchtstärke erzielt werden kann, kann bei großflächigen OLEDs ein besonders homogenes Leuchtbild erzielt werden. Weiterhin führt die geringe notwendige Leistung zu einer geringen Wärmeentwicklung. Dieser Aspekt hat seine Ursache in dem Stapeln der aktiven Schichten, die nur eine geringe Leuchtdichte bereitstellen müssen. Ein wesentlicher Aspekt für das Stapeln von aktiven Schichten in einer Schichtfolge ist dabei, dass über die Ladungserzeugungsschichtfolge 100 genügend Ladungsträger bereitgestellt werden und dass die Absorption der in der aktiven Schicht emittierten Strahlung durch die Verwendung des Kupferkomplexes weitgehend vermieden wird.

Dies gilt dabei nicht nur für das Anwendungsgebiet der Emittervorrichtungen, wie der OLED. In anderen Ausführungsbeispielen des optoelektronischen Bauelements 300 kann wenigstens eine der ersten aktiven Schicht 310 und der zweiten aktiven Schicht 312 eine Detektorschicht sein, bspw. eine photovoltaische Schicht oder ein Photodetektor. Im Fall eines hybriden Systems, bei dem beispielsweise die erste aktive Schicht 310 eine emittierende Schicht und die zweite aktive Schicht 312 eine detektierende Schicht darstellt, ist es denkbar, dass die zweite aktive Schicht 312 elektromagnetische Strahlung in einem Wellenlängenbereich detektiert, in dem von der ersten aktiven Schicht 310 keine oder ein geringer Anteil an elektromagnetischer Strahlung emittiert wird. Ebenso ist es denkbar, dass die zweite aktive Schicht 312 im Sinne eines Detektors gerade in einem Bereich der Emissionswellenlängen der ersten aktiven Schicht 310 Strahlung detektiert.

Insgesamt bietet gerade der Aufbau eines optoelektronischen Bauelements mit einer den Kupferkomplex enthaltenden Ladungserzeugungsschichtfolge 100 die Möglichkeit, besonders effiziente optoelektronische Bauelemente bereitzustellen.

### ZWEITES AUSFÜHRUNGSBEISPIEL DES OPTOELEKTRONISCHEN BAUELEMENTS

**Fig.4** zeigt die schematische Darstellung eines zweiten Ausführungsbeispiels eines optoelektronischen Bauelements 400. Dabei unterscheidet sich das zweite Ausführungsbeispiel von dem ersten Ausführungsbeispiel der **Fig.3** in der Schichtfolge zwischen der Anode 302 und der Kathode 304. Der Schichtstapel des zweiten Ausführungsbeispiels weist eine zweite Ladungserzeugungsschichtfolge 402 und eine dritte aktive Schicht 404 auf, die zwischen der zweiten aktiven Schicht 312 und der elektronentransportierenden Schicht 314 angeordnet sind.

Das optoelektronische Bauelement 400 weist damit eine Stapelstruktur aus drei aktiven Schichten auf. Die Stapelstruktur (oder *stacked* device) kann auch weitere Stapel (*stack*) aus einer Ladungserzeugungsschichtfolge und einer aktiven Schicht aufweisen. Prinzipiell ist es denkbar, eine Struktur mit beliebig vielen *stacks* bereitzustellen. Eine Stapelstruktur mit zwei aktiven Schichten wird beispielsweise auch als Tandemstruktur bezeichnet. Ähnliche Strukturen sind beispielsweise aus dem Dokument [3] oder dem Dokument [4] bekannt.

Die Stapelstruktur ist insbesondere geeignet, eine OLED bereitzustellen, die weißes Licht emittiert. Dabei ist die Ausführung mit drei verschiedenen Stapeln, wie im Fall des dritten Ausführungsbeispiels, besonders vorteilhaft. So kann beispielsweise ein sogenannter "RGB-Emitter" bereitgestellt werden, in dem je eine aktive Schicht ein rotes, ein grünes oder ein blaues Farbspektrum emittiert. Damit kann ein genauer Farbort des insgesamt emittierten Spektrums eingestellt werden. Durch die Aufteilung in drei aktive Schichten kann beispielsweise jedes verwendete Emittermaterial in eine optisch optimale Position innerhalb des Schichtstapels eingebracht sein. Dabei können Effekte, wie Absorption unterschiedlicher Wellenlängen oder Brechungsindizes an Grenzflächen berücksichtigt sein.

Es ist selbstverständlich, dass das oben gesagte auch in analoger Weise für eine optoelektronische Vorrichtung 400 gilt, in der wenigstens eine der aktiven Schichten als Detektor wirkt.

### DRITTES AUSFÜHRUNGSBEISPIEL DES OPTOELEKTRONISCHEN BAUELEMENTS

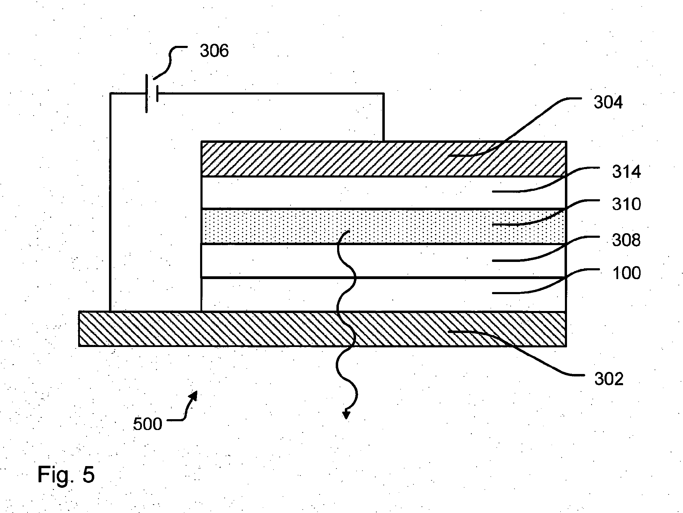

**Fig.5** zeigt die schematische Darstellung eines dritten Ausführungsbeispiels eines optoelektronischen Bauelements 500 mit einer Ladungserzeugungsschichtfolge 100. Das dritte Ausführungsbeispiel unterscheidet sich von dem ersten Ausführungsbeispiel dadurch, dass lediglich eine aktive Schicht vorgesehen ist. Diese ist zwischen der elektronentransportierenden Schicht 314 und der lochtransportierenden Schicht 308 angeordnet. Die Ladungserzeugungsschichtfolge 100 ist zwischen der Anode 302 und der lochtransportierenden Schicht 308 angeordnet.

Durch die Anordnung der Ladungserzeugungsschichtfolge 100 an der Anode 302 können leichter Ladungsträger, d.h. insbesondere Löcher, in den Schichtstapel eingebracht werden. Dies ist besonders geeignet, um Effekte durch eine Austrittsarbeit des Anodenmaterials zu unterdrücken, die gegebenenfalls zu einer Hemmung des Transports von Löchern in den Schichtstapel führen können. Die Ladungserzeugungsschichtfolge 100 hat damit nicht die Wirkung, zusätzliche Ladungsträger in dem Schichtstapel bereitzustellen. Vielmehr unterstützt sie beispielsweise den Eintritt von Ladungsträgern von metallischen Elektroden in organische Materialien des Schichtstapels. Diese Funktion der Ladungserzeugungsschichtfolge 100 kann auch in Kombination mit den Anordnungen des optoelektronischen Bauelements des ersten oder zweiten Ausführungsbeispiels oder in beliebig anderen Ausführungsformen verwendet werden.

### ABSCHLIESSENDE FESTSTELLUNG

Das optoelektronische Bauelement wurde zur Veranschaulichung des zugrundeliegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso möglich, in Ausführungsbeispielen einzelne dargestellte Merkmale oder besondere Ausgestaltungen wegzulassen oder hinzuzufügen, soweit die allgemeine technische Lehre realisiert bleibt.

### LITERATUR

In diesem Dokument sind die folgenden Veröffentlichungen zitiert:
[1] Kröger, M. et al. "Temperature-independent field induced charge separation of doped organic/organic interfaces: Experimental modeling of electrical properties": Phys. Rev. B 75, 235321 (2007*) ;*
[2] Meerheim, R. et al. "Ultrastable and efficient red organic light emitting diodes with doped transport layers": Appl. Phys. Lett. 89, 061111 (2006);
[3] EP 1 983 805 A1;
[4] Lee, T. et al. "High-efficiency stacked white organic light emitting diodes": Appl. Phys. Lett. 92, 043301 (2008)
[5] US 2005/260451 A1 (KIJIMA YASUNORI [JP]) 24. November 2005 (2005-11-24).
[6] EP 1 351 558 A1 (KIDO JUNJI [JP]; INTERNAT MFG AND ENGINEERING S [JP] KIDO JUNJI [JP];) 8. Oktober 2003 (2003-10-08)
[7] YULIA SEVRYUGINA ET AL: "Tetranuclear copper(i) clusters: impact of bridging carboxylate ligands on solid state structure and photoluminescence", Chem. Commun., 2007, 3853-3855.
[8] SEVRYUGINA ET AL: "X-ray structure and photoluminescence of copper(I) 2,6-bis(trifluoromethyl)benzoate", Inorg. Chim. Acta, 2007, 360, 3103-3107.
[9] SHARMA R P ET AL: "Segregated aromatic π-π stacking interactions involving fluorinated and non-fluorinated benzene rings: Cu(py)2 (pfb)2 and Cu(py)2 (pfb)2 (H2 O) (py=pyridine and pfb=pentafluorobenzoate)", J. Fluor. Chem., 2010, 131, 456-460.

**BEZUGSZEICHENLISTE**

| | |
|---|---|
| Ladungserzeugungsschichtfolge | 100 |
| Erste organische Halbleiterschicht | 102 |
| Zweite organische Halbleiterschicht | 104 |
| Grenzfläche | 106 |
| Ladungsträgerpaar | 108 |
| Zwischenschicht | 110 |
| LUMO-Energieniveau | 200 |
| HOMO-Energieniveau | 202 |
| Optoelektronisches Bauelement | 300 |
| Anode | 302 |
| Kathode | 304 |
| Stromquelle | 306 |
| Lochtransportierende Schicht | 308 |
| Erste aktive Schicht | 310 |
| Zweite aktive Schicht | 312 |
| Elektronentransportierende Schicht | 314 |
| Optoelektronisches Bauelement | 400 |
| Zweite Ladungserzeugungsschichtfolge | 402 |
| Dritte aktive Schicht | 404 |
| Optoelektronisches Bauelement | 500 |
| Elektrisches Feld | **E** |

## Patentansprüche

1. Optoelektronisches Bauelement (300, 400, 500) mit einer organischen Schichtstruktur (100, 402) zum Trennen von Ladungsträgern eines ersten Ladungsträgertyps und Ladungsträgern eines zweiten Ladungsträgertyps, **dadurch gekennzeichnet, dass** die organische Schichtstruktur (100, 402) einen Kupferkomplex umfasst, der wenigstens einen Liganden mit der chemischen Struktur gemäß Formel I aufweist: 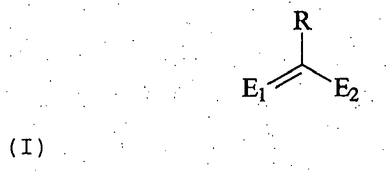 worin E₁ und E₂ jeweils unabhängig voneinander eines der folgenden Elemente sind: Sauerstoff, Schwefel oder Selen, und R ausgewählt ist aus der Gruppe: Wasserstoff oder substituierter oder unsubstituierter, verzweigter, linearer oder zyklischer Kohlenwasserstoffe.

2. Optoelektronisches Bauelement (300, 400, 500) gemäß Patentanspruch 1, wobei der Kupferkomplex ein Kupfer (I) penta-Fluor-Benzoat ist.

3. Optoelektronisches Bauelement (300, 400, 500) gemäß einem der vorangehenden Patentansprüche, wobei der Kupferkomplex als Dotierstoff in einem Matrixmaterial eingebracht ist.

4. Optoelektronisches Bauelement (300, 400, 500) gemäß Patentanspruch 3, wobei das Matrixmaterial 1-TNATA (4,4',4" -tris(N-(1-naphthyl)-N-phenyl-amino)Triphenylamin aufweist.

5. Optoelektronisches Bauelement (300, 400, 500) gemäß einem der vorangehenden Patentansprüche, wobei die organische Schichtstruktur (100, 402) eine Ladungserzeugungsschichtfolge ist.

6. Optoelektronisches Bauelement (300, 400, 500) gemäß einem der vorangehenden Patentansprüche, wobei die organische Schichtstruktur (100, 402) eine mit dem Kupferkomplex p-dotierte organische Halbleiterschicht (104) und eine n-dotierte organische Halbleiterschicht (102) aufweist.

7. Optoelektronisches Bauelement (300, 400, 500) gemäß Patentanspruch 6, wobei zwischen der p-dotierten organischen Halbleiterschicht (104) und der n-dotierten organischen Halbleiterschicht (102) eine Zwischenschicht (110) angeordnet ist.

8. Optoelektronisches Bauelement (300, 400, 500) gemäß einem der Patentansprüche 6 oder 7, wobei die p-dotierte organische Halbleiterschicht (104) einen Dotierungsgradienten hin zu der n-dotierten organischen Halbleiterschicht (102) aufweist.

9. Optoelektronisches Bauelement (300, 400, 500) gemäß Patentanspruch 8, wobei die Dotierung der p-dotierten organischen Halbleiterschicht (104) hin zu der n-dotierten organische Halbleiterschicht (102) zunimmt.

10. Optoelektronisches Bauelement (300, 400, 500) gemäß einem der vorangehenden Patentansprüche mit einem die organische Schichtstruktur (100, 402) umfassenden Schichtstapel.

11. Optoelektronisches Bauelement (300, 400, 500) gemäß Patentanspruch 10, wobei der Schichtstapel wenigstens eine aktive Schicht (310, 312, 404) aufweist.

12. Optoelektronisches Bauelement (300, 400, 500) gemäß Patentanspruch 11, wobei die aktive Schicht (310, 312, 404) ein elektrolumineszentes Material aufweist.

13. Optoelektronisches Bauelement (300, 400, 500) gemäß einem der Patentansprüche 11 bis 12, wobei die organische Schichtstruktur (100, 402) zwischen einer ersten aktiven Schicht (310) und einer zweiten aktiven Schicht (312) angeordnet ist.

14. Optoelektronisches Bauelement (300, 400, 500) gemäß einem der Patentansprüche 9 bis 13, wobei die organische Schichtstruktur auf einer Elektrode, insbesondere einem Anodenkontakt (302), aufgebracht ist.

15. Verwendung eines Kupferkomplexes in einer organischen Schichtstruktur (100, 402), die zum Trennen von Ladungsträgern eines ersten Ladungsträgertyps und Ladungsträgern eines zweiten Ladungsträgertyps ausgelegt ist, **dadurch gekennzeichnet, dass** der Kupferkomplex wenigstens einen Liganden mit der chemischen Struktur gemäß Formel I aufweist: 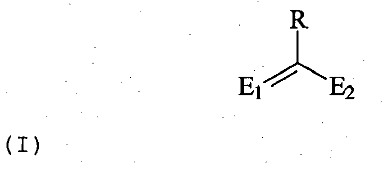 worin E₁ und E₂ jeweils unabhängig voneinander eines der folgenden Elemente sind: Sauerstoff, Schwefel oder Selen, und R ausgewählt ist aus der Gruppe: Wasserstoff oder substituierter oder unsubstituierter, verzweigter, linearer oder zyklischer Kohlenwasserstoffe.

## Claims

1. Optoelectronic component (300, 400, 500) having an organic layer structure (100, 402) for separating charge carriers of a first charge carrier type and charge carriers of a second charge carrier type, **characterized in that** the organic layer structure (100, 402) comprises a copper complex which has at least one ligand with the chemical structure according to formula I: 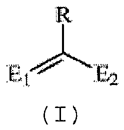 in which E₁ and E₂ in each case independently of one another are one of the following elements: oxygen, sulfur, or selenium, and R is selected from the following group: hydrogen or substituted or unsubstituted, branched, linear, or cyclic hydrocarbons.

2. Optoelectronic component (300, 400, 500) according to Claim 1, where the copper complex is a copper(I) pentafluorobenzoate.

3. Optoelectronic component (300, 400, 500) according to either of the preceding claims, where the copper complex is incorporated as dopant in a matrix material.

4. Optoelectronic component (300, 400, 500) according to claim 3, where the matrix material comprises 1-TNATA (4,4',4"-tris(N-(1-naphthyl)-N-phenylamino)triphenylamine.

5. Optoelectronic component (300, 400, 500) according to any of the preceding claims, where the organic layer structure (100, 402) is a charge generation layer sequence.

6. Optoelectronic component (300, 400, 500) according to any of the preceding claims, where the organic layer structure (100, 402) comprises an organic semiconductor layer (104) p-doped with the copper complex, and an n-doped organic semiconductor layer (102).

7. Optoelectronic component (300, 400, 500) according to claim 6, where an interlayer (110) is disposed between the p-doped organic semiconductor layer (104) and the n-doped organic semiconductor layer (102).

8. Optoelectronic component (300, 400, 500) according to either of claims 6 and 7, where the p-doped organic semiconductor layer (104) has a doping gradient toward the n-doped organic semiconductor layer (102).

9. Optoelectronic component (300, 400, 500) according to claim 8, where the doping of the p-doped organic semiconductor layer (104) increases toward the n-doped organic semiconductor layer (102).

10. Optoelectronic component (300, 400, 500) according to any of the preceding claims, having a layer stack comprising the organic layer structure (100, 402).

11. Optoelectronic component (300, 400, 500) according to claim 10, where the layer stack comprises at least one active layer (310, 312, 404).

12. Optoelectronic component (300, 400, 500) according to claim 11, where the active layer (310, 312, 404) comprises an electroluminescent material.

13. Optoelectronic component (300, 400, 500) according to either of claims 11 and 12, where the organic layer structure (100, 402) is disposed between a first active layer (310) and a second active layer (312).

14. Optoelectronic component (300, 400, 500) according to any of claims 9 to 13, where the organic layer structure is applied on an electrode, more particularly on an anode contact (302).

15. Use of a copper complex in an organic layer structure (100, 402) which is designed for separating charge carriers of a first charge carrier type and charge carriers of a second charge carrier type, **characterized in that** the copper complex comprises at least one ligand with the chemical structure according to formula I: 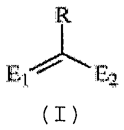 in which E₁ and E₂ in each case independently of one another are one of the following elements: oxygen, sulfur, or selenium, and R is selected from the following group: hydrogen or substituted or unsubstituted, branched, linear, or cyclic hydrocarbons.

## Revendications

1. Composant optoélectronique (300, 400, 500) présentant une structure organique stratifiée (100, 402) qui sépare des porteurs de charge d'un premier type de porteurs de charge et des porteurs de charge d'un deuxième type de porteurs de charge,
**caractérisé en ce que**
la structure organique stratifiée (100, 402) comporte un complexe de cuivre qui présente au moins un ligand dont la structure chimique est conforme à la formule I 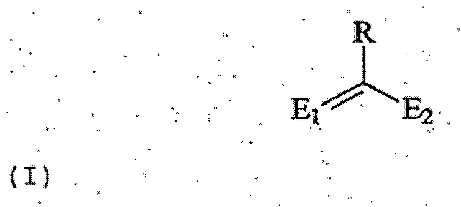 dans laquelle E₁ et E₂ représentent chacun indépendamment l'un de l'autre l'un des éléments suivants : oxygène, soufre ou sélénium, R étant sélectionné dans l'ensemble constitué de l'hydrogène et des hydrocarbures substitués ou non substitués, ramifiés, linéaires ou cycliques.

2. Composant optoélectronique (300, 400, 500) selon la revendication 1, dans lequel le complexe de cuivre est un penta-fluorobenzoate de cuivre (I).

3. Composant optoélectronique (300, 400, 500) selon l'une des revendications précédentes, dans lequel le complexe de cuivre est incorporé en tant que substance de dopage dans un matériau de matrice.

4. Composant optoélectronique (300, 400, 500) selon la revendication 3, dans lequel le matériau de matrice présente du 1-TNATA (4,4',4''-tris(N-(1-naphtyl)-N-phénylamino).

5. Composant optoélectronique (300, 400, 500) selon l'une des revendications précédentes, dans lequel la structure organique stratifiée (100, 402) est une succession de couches de production de charges.

6. Composant optoélectronique (300, 400, 500) selon l'une des revendications précédentes, dans lequel la structure organique stratifiée (100, 402) présente une couche semi-conductrice organique (104) à dopage p par le complexe de cuivre et une couche organique semi-conductrice (102) à dopage n.

7. Composant optoélectronique (300, 400, 500) selon la revendication 6, dans lequel une couche intermédiaire (110) est disposée entre la couche organique semi-conductrice (104) à dopage p et la couche organique semi-conductrice (102) à dopage n.

8. Composant optoélectronique (300, 400, 500) selon l'une des revendications 6 ou 7, dans lequel la couche organique semi-conductrice (104) à dopage p présente un gradient de dopage en direction de la couche organique semi-conductrice (102) à dopage n.

9. Composant optoélectronique (300, 400, 500) selon la revendication 8, dans lequel le dopage de la couche organique semi-conductrice (104) à dopage p augmente en direction de la couche organique semi-conductrice (102) à dopage n.

10. Composant optoélectronique (300, 400, 500) selon l'une des revendications précédentes, présentant un empilement de couches comprenant la structure organique stratifiée (100, 402).

11. Composant optoélectronique (300, 400, 500) selon la revendication 10, dans lequel l'empilement de couches présente au moins une couche active (310, 312, 404).

12. Composant optoélectronique (300, 400, 500) selon la revendication 11, dans lequel la couche active (310, 312, 404) présente un matériau électroluminescent.

13. Composant optoélectronique (300, 400, 500) selon l'une des revendications 11 à 12, dans lequel la structure organique stratifiée (100, 402) est disposée entre une première couche active (310) et une deuxième couche active (312).

14. Composant optoélectronique (300, 400, 500) selon l'une des revendications 9 à 13, dans lequel la structure organique stratifiée est appliquée sur une électrode et en particulier sur un contact d'anode (302).

15. Utilisation d'un complexe de cuivre dans une structure organique stratifiée (100, 402) conçue pour séparer des porteurs de charge d'un premier type de porteurs de charge et de porteurs de charge d'un deuxième type de porteurs de charge,
**caractérisée en ce que**
le complexe de cuivre présente au moins un ligand dont la structure chimique est conforme à la formule I 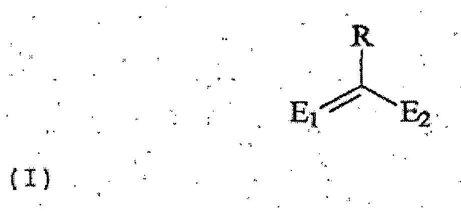 dans laquelle E₁ et E₂ représentent chacun indépendamment l'un de l'autre l'un des éléments suivants : oxygène, soufre ou sélénium, R étant sélectionné dans l'ensemble constitué de l'hydrogène et des hydrocarbures substitués ou non substitués, ramifiés, linéaires ou cycliques.
